Europäisches Patentamt

European Patent Office

Office européen des brevets

(11) Veröffentlichungsnummer: **0 472 034 A1**

# (12) EUROPÄISCHE PATENTANMELDUNG

(21) Anmeldenummer: **91113019.3**

(22) Anmeldetag: **02.08.91**

(51) Int. Cl.5: **C08K 13/04**, C08L 81/02,
//(C08K13/04,5:32,7:14)

(30) Priorität: **15.08.90 DE 4025783**

(43) Veröffentlichungstag der Anmeldung:
**26.02.92 Patentblatt 92/09**

(84) Benannte Vertragsstaaten:
**BE DE FR GB IT**

(71) Anmelder: **BAYER AG**

**W-5090 Leverkusen 1 Bayerwerk(DE)**

(72) Erfinder: **Köhler, Burkhard, Dr.**
**Mündelheimer Strasse 94**
**W-4150 Krefeld 11(DE)**
Erfinder: **Rüsseler, Wolfgang, Dr.**
**Buschstrasse 165**
**W-4150 Krefeld 1(DE)**
Erfinder: **Döring, Joachim, Dr., c/o BAYER**
**JAPAN Ltd.**
**108 Takanawa 4-Chome**
**Minatoku, Tokyo 108(JP)**
Erfinder: **Heinz, Hans-Detlef, Dr.**
**Breslauer Strasse 31**
**W-4150 Krefeld 11(DE)**

(54) **Mischungen aus Polyarylensulfiden, Nitroarylmethyliden-Ketonen, Glasfasern und gegebenenfalls weiteren Füllstoffen.**

(57) Die Erfindung betrifft Mischungen aus Polyarylensulfiden, Nitroarylmethyliden-Ketonen, Glasfasern und gegebenenfalls weiteren Füllstoffen. Die Mischungen zeichnen sich durch gute mechanische Eigenschaften aus.

EP 0 472 034 A1

Die Erfindung betrifft Mischungen aus Polyarylensulfiden, Epoxiden, Säureanhydriden, Glasfasern und gegebenenfalls weiteren Füll(zusatz)stoffen. Die Mischungen zeichnen sich durch gute mechanische Eigenschaften aus.

Polyarylensulfide (PAS) sind bekannt (z.B. US-A 3 354 129, EP-A 171 021). Sie sind inerte, hochtemperaturbeständige Thermoplaste, die einen hohen Füllgrad, z.B. mit Glasfasern und/oder anderen anorganischen Füllstoffen erlauben. Der Einsatz dieser Polymeren, insbesondere des Polyphenylensulfids (PPS) nimmt in Bereichen zu, die bisher Duroplasten vorbehalten waren.

PAS hat unbefriedigende mechanische Eigenschaften für einige Anwendungen im Spritzgußbereich. Insbesondere sind Randfaserdehnung und Schlagzähigkeit für die Praxis nicht ausreichend. Es hat sich daher als Vorteil erwiesen, PAS z.B. durch Abmischung mit anderen Thermoplasten in den genannten Eigenschaften zu verbessern, Die Verbesserung der mechan. Eigenschaften von PAS gelingt auch mit Mischungen aus Maleinsäureanhydrid-gepfropften, hydrierten Dienkautschuken und Epoxiden (JP-A 63-118369). Die großen Mengen an verwendeten Maleinsäureanhydrid-gepfropften Polyolefinen mit niedriger Glastemperatur verbessern die Zähigkeit, jedoch läßt sich die Biegefestigkeit nicht wesentlich steigern.

Für bestimmte Anwendungsgebiete ist das Eigenschaftsprofil derartiger Abmischungen jedoch nicht immer ganz befriedigend.

Es wurde nun gefunden, daß Abmischungen von Polyphenylensulfid (PPS) mit Nitroarylmethyliden-Ketonen, Glasfasern und gegebenenfalls weiteren Zusätzen sich durch ihre mechanischen Eigenschaften auszeichnen.

Gegenstand der Erfindung sind daher Mischungen aus

A) 89,9 bis 20 Gew.-% Polyarylensulfiden, vorzugsweise Polyphenylensulfid,

B) 0,1 bis 5 Gew.-%, der Umsetzungsprodukte von mono-, oligo- oder Polyketonen, die pro Molekül mindestens zwei zu Ketogruppen vicinale Methylengruppen enthalten, mit Nitroarylaldehyden der Formel (I)

$$(O_2N)_n\text{-Ar-}(CHO)_m \qquad (I),$$

wobei

Ar    für einen $C_{6-14}$-divalenten aromatischen Rest,

n    für 1 oder 2 und

m    für 1 oder 2 steht,

C) 10 bis 79,9 Gew.-%, vorzugsweise

30 bis 60 Gew.-% Glasfasern,

die vorzugsweise mit Polyurethanfilmbildnern und Aminosilan- oder Epoxysilanhaftvermittlern, besonders bevorzugt Aminosilanhaftvermittlern geschlichtet sind und gegebenenfalls bis zu 300 Gew.-%, bezogen auf PAS anderen mineralischen oder organischen Füll- und Verstärkungsstoffen und/oder anorganischen oder organischen Hilfsstoffen.

Bevorzugte Stoffe der Formel (I) sind 2-, 3- und 4-Nitrobenzaldehyd.

Sie werden vorzugsweise mit Aceton, Butanon, Diethylketon, Cyclopentanon, Cyclohexanon, oder Cyclodecanon zu den entsprechenden Dinitrobenzalketonen umgesetzt, die dann als erfindungsgemäße Additive B) eingesetzt werden können.

Die Substanzen B) sind zum größten Teil bekannt und können z.B. durch eine mit NaOH katalysierte Aldolreaktion in Methanol, z.B. analog Organikum, VEB-Verlag, Berlin, 1973, 12. Aufl., Seite 504, hergestellt werden.

Erfindungsgemäß werden handelsübliche, bevorzugt mit Polyurethanfilmbildnern und Aminosilan- oder Epoxysilanhaftvermittlern geschlichtete Glasfasern eingesetzt. Sie haben einen Durchmesser von 1 bis 20 $\mu$m, vorzugsweise von 5 bis 13 $\mu$m. Es können Endlosglasfasern eingesetzt werden und/oder Herstellungsverfahren gewählt werden, bei denen die Länge der Fasern in der fertigen Abmischung 0,05 bis 10 mm, vorzugsweise 0,1 bis 2 mm, beträgt. Es können auch Endlosfasern (Rovings) eingesetzt werden in Verfahren zur Herstellung von endlosverstärktem Unidirektionalverbund.

Gegebenenfalls können auch - insbesondere teilweise - anstelle der Glasfasern handelsübliche Glaskugeln eingesetzt werden, z.B. Ballotini-Glaskugeln.

Als weitere, mineralische Füllstoffe oder Zusatzstoffe seien Glimmer, Talkum, Quarzmehl, Metalloxide und Sulfide, z.B. $TiO_2$, $ZnO$, $ZnS$, Graphit, Ruß, Fasern, z.B. aus Quarz oder Kohlenstoff, Carbonate wie z.B. $MgCO_3$, $CaCO_3$, Sulfate wie z.B. $CaSO_4$, $BaSO_4$, genannt.

Als weitere übliche Zusatzstoffe können Pigmente, Entformungsmittel, E-Wachse, Fließhilfsmittel, Nucleierungsmittel oder Stabilisatoren eingesetzt werden.

Es können 0 bis 300 Gew.-%, bezogen auf PAS, Füll- und Zusatzstoffe eingesetzt werden.

Die erfindungsgemäßen Mischungen können auf übliche Art und Weise durch Extrusion hergestellt werden.

Die erfindungsgemäßen Mischungen können auf übliche Weise zu Formteilen, Halbzeug, Leiterplatten, Fasern, Folien, Profilen usw. verarbeitet werden. Die erfindungsgemäßen Mischungen können generell in vorteilhafter Weise dort eingesetzt werden, wo thermoplastisch verarbeitbare Massen eingesetzt werden.

Beispiele

Die Herstellung der erfindungsgemäßen Mischungen erfolgte auf einem Doppelwellenextruder ZSK 32 von Werner und Pfleiderer bei 320° C.

Das verwendete PPS wies eine Schmelzviskosität von 45 Pas (360° C), Schubspannung = 1000 $s^{-1}$ auf und wurde nach EP-A 171 021 hergestellt.

Als Glasfasern wurde die mit Polyurethanfilmbildner und Aminosilanhaftvermittler geschlichtete Schnittglasfaser Bayer CS 7916® zu 40 Gew.-% eingesetzt.

Die Mischungen wurden granuliert und zu Prüfstäben (z.B. der Maße 80 x 10 x 4 mm) verspritzt. Diese wurden hinsichtlich Beigefestigkeit, Randfaserdehnung, Biegemodul und Schlagzähigkeit $a_n$ (reversed notched ISO 180) untersucht.

Vergleichsbeispiel

Gemischt wurden 60 Gew.-% PPS mit 40 Gew.-% Glasfaser.

Beispiel 1

Gemischt wurden 59 Gew.-% PPS mit 40 Gew.-% Glasfaser, und 1 Gew.% 2,6-Bis-(4-nitrobenzal)-cyclohexanon.

Folgende Tabelle faßt die mechanischen Eigenschaften zusammen.

| Beispiel | Biegefestigkeit (MPa) | Randfaserdehnung (%) | Biegemodul (MPa) | Izod-Schlagzähigkeit ($kJ/m^2$) |
|---|---|---|---|---|
| Vergleich | 250 | 1,9 | 13.000 | 30 |
| 1 | 299 | 2,4 | 12.800 | 44 |

**Patentansprüche**

1. Mischungen aus

   A) 89,9 bis 20 Gew.-% Polyarylensulfiden,

   B) 0,1 bis 5 Gew.-% der Umsetzungsprodukte von mono-, oligo- oder Polyketonen, die pro Molekül mindestens zwei Ketogruppen vicinale Methylengruppen enthalten, mit Nitroarylaldehyden der Formel (I)

   $(O_2N)_n$-Ar-$(CHO)_m$      (I),

   wobei

   Ar     für einen $C_{6-14}$-divalenten aromatischen Rest,

   n      für 1 oder 2 und

   m      für 1 oder steht,

   C) 10 bis 79,9 Gew.-% Glasfasern,

   die gegebenenfalls mit Polyurethanfilmbildnern und Aminosilan- oder Epoxysilanhaftvermittlern, besonders bevorzugt Aminosilanhaftvermittlern geschlichtet sind und gegebenenfalls bis zu 300 Gew.-%, bezogen auf PAS anderen mineralischen oder organischen Füll- und Verstärkungsstoffen und/oder anorganischen oder organischen Hilfsstoffen.

2. Verwendung der Mischungen nach Anspruch 1, zur Herstellung geformter Körper.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 345 550 (BAYER AG) <br> * Seite 4, Zeile 47 - Zeile 49; Ansprüche 1-3,5 * <br><br> --- | 1-2 | C08K13/04 <br> C08L81/02 <br> //(C08K13/04, <br> 5:32,7:14) |
| A | EP-A-0 345 551 (BAYER AG) <br> * Seite 2, Zeile 35 - Zeile 44; Anspruch 1 * <br> --- | 1 | |
| P,A | EP-A-0 428 020 (BAYER AG) <br> * Ansprüche 1-3; Beispiele 1-2 * <br><br> ----- | 1-2 | |
| | | | RECHERCHIERTE SACHGEBIETE (Int. Cl.5) <br><br> C08K |

Der vorliegende Recherchenbericht wurde für alle Patentansprüche erstellt

| Recherchenort | Abschlußdatum der Recherche | Prüfer |
|---|---|---|
| DEN HAAG | 25 NOVEMBER 1991 | FUHR C.K.B. |